# EUROPEAN PATENT APPLICATION

(11) **EP 4 770 412 A1**
(43) Date of publication of application: **01.07.2026**
(21) Application number: 25218437.9
(22) Date of filing: 25.11.2025
(51) Int. Cl.: H10W 70/66

(54) **CONDUCTIVE LIQUID METAL MATRIX**

(30) Priority: 30.12.2024 US 202419005495
(71) Applicant: INTEL Corporation, Santa Clara, CA 95054 (US)
(72) Inventor: MEYYAPPAN, Karumbu, Portland, 97229 (US); MURTAGIAN, Gregorio R., Phoenix, 85045 (US)
(74) Representative: 2SPL Patentanwälte PartG mbB

(57) **Abstract**

Embodiments disclosed herein include an apparatus that comprises a first substrate with a first pad on the first substrate, where the first pad is electrically conductive, and a second substrate over the first substrate with a second pad on the second substrate, where the second pad is electrically conductive. In an embodiment, the apparatus further comprises a patch between the first substrate and the second substrate. In an embodiment, the patch comprises a frame with an opening through the frame, and an interconnect within the opening. In an embodiment, the interconnect electrically couples the first pad to the second pad, and the interconnect comprises a liquid metal matrix with filler particles that are electrically conductive.

## Description

### BACKGROUND

The use of liquid metal interconnects in electronics packaging is growing as electrical demands continue to increase in the industry. Liquid metal is a metallic material that is in a liquid phase at temperatures at, or around, room temperature. For example, liquid metal may comprise gallium. In some liquid metal interconnect architectures, a patch is provided on the bottom surface of the package substrate. The patch includes wells, and the liquid metal is provided in the wells. Often, the wells are sealed with a cap layer. In order to allow for repeated socketing processes (e.g., for testing, upgrading, etc.) the cap layer may be a self-healing material. A pin from the board side penetrates the cap layer in order to make contact with the liquid metal.

### BRIEF DESCRIPTION OF THE DRAWINGS

Figure 1 is a cross-sectional illustration of a liquid metal interconnect between a first substrate and a second substrate where a pin passes through a capping layer to contact a confined well of liquid metal, in accordance with an embodiment.
Figure 2A is a cross-sectional illustration of a liquid metal matrix interconnect between a first substrate and a second substrate where the liquid metal matrix interconnect is a paste, in accordance with an embodiment.
Figure 2B is a cross-sectional illustration of a liquid metal matrix interconnect between a first substrate and a second substrate where the patch comprising the liquid metal matrix interconnect is secured to the first substrate by an adhesive, in accordance with an embodiment.
Figure 2C is a cross-sectional illustration of a liquid metal matrix interconnect between a first substrate and a second substrate, in accordance with an additional embodiment.
Figures 3A - 3D are cross-sectional illustrations depicting a process for electrically coupling a first substrate to a second substrate with a patch that comprises liquid metal matrix interconnects, in accordance with an embodiment.
Figure 4 is a flow diagram that describes a process for electrically coupling a first substrate to a second substrate with a patch that comprises liquid metal matrix interconnects, in accordance with an embodiment.
Figure 5A is a cross-sectional illustration of an electronic system with a stack of memory dies coupled to an interposer with liquid metal matrix interconnects, in accordance with an embodiment.
Figure 5B is a cross-sectional illustration of an electronic system with a pair of dies coupled to a package substrate with liquid metal matrix interconnects and a board coupled to the package substrate with liquid metal matrix interconnects, in accordance with an embodiment.
Figure 5C is a cross-sectional illustration of an electronic system with a pair of dies coupled to a package substrate with liquid metal matrix interconnects and a board coupled to the package substrate with solder interconnects, in accordance with an embodiment.
Figure 6 is a schematic of a computing device built in accordance with an embodiment.

### EMBODIMENTS OF THE PRESENT DISCLOSURE

Described herein are conductive liquid metal matrix interconnect architectures that are based on a mixture of a liquid metal and conductive particles, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

As noted above, liquid metal interconnect architectures are a promising solution to replace existing second level interconnect (SLI) solutions, such as separable sockets (e.g., land grid array (LGA), pin grid array (PGA), low insertion force (LIF) technologies, etc.) or test sockets (e.g. elastomeric sockets, buckling beam probes, etc.). All of these technologies rely on some type of mechanical spring functionality in order to provide a desired working range. As the number of interconnects continues to increase, the force required to compress the spring mechanism for all of the interconnects rapidly increases to a point that is impractical. Further, each of these interconnect solutions rely on high conductivity material, such as copper or an alloy of copper. However, poor bulk resistance is still an issue due to the small cross-sectional area and relatively high interface resistance (which is a function of the applied contact force).

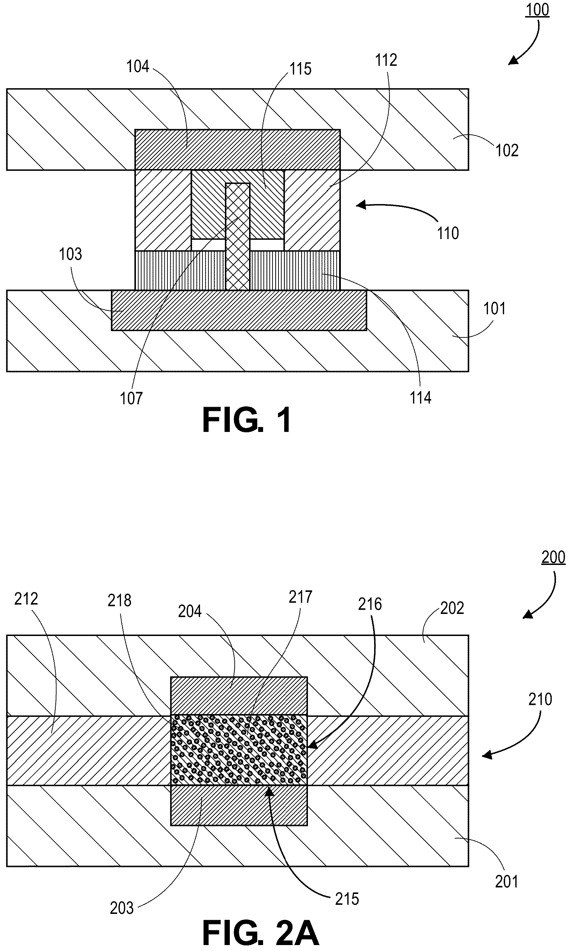

Liquid metal interconnects avoid issues related to compressing mechanical spring mechanisms. Further, the liquid nature allows for excellent electrical contact between the liquid metal and electrical pads. However, liquid metal interconnects are not without issue. One issue is that liquid metal is difficult to handle since it is in a liquid phase at room temperature. Accordingly, interconnect frames (or patches) include capping layers over the holes in order to retain the liquid metal. As such, a pin needs to puncture the capping layer in order to contact the liquid metal to provide the electrical connection. An example of such a liquid metal interconnect solution is shown in Figure 1.

Referring now to Figure 1, a cross-sectional illustration of portion of a device 100 is shown, in accordance with an embodiment. In an embodiment, the device 100 may include a first substrate 101 that is electrically coupled to a second substrate 102 by a liquid metal interconnect 110. The first substrate 101 and the second substrate 102 may be any typical substrates used in electronics packaging. For example, the first substrate 101 may be a board, and the second substrate 102 may be a package substrate. In an embodiment, a first pad 103 is provided on the first substrate 101, and a second pad 104 is provided on the second substrate 102.

In an embodiment, the liquid metal interconnect 110 may comprise a frame 112. The frame 112 may comprise a polymeric material or the like. The frame 112 may include an opening or well in order to confine a liquid metal 115. As used herein, "liquid metal" refers to an electrically conductive material that is in the liquid phase at (or around) room temperature. In some instances, the liquid metal may maintain a liquid phase at temperatures down to zero degrees Celsius. In an embodiment, the liquid metal 115 may comprise gallium with or without any other alloying elements.

In an embodiment, a capping layer 114 may be provided between the liquid metal interconnect 110 and the first pad 103. The capping layer 114 may be a healable material that allows for a pin 107 from the first pad 103 to be inserted through and removed from the well without allowing the liquid metal 115 to leak from the well. As such, the liquid metal interconnect 110 is removable, similar to a socket architecture. In an embodiment, the liquid metal 115 contacts the pin 107 and the second pad 104. This allows for an electrical coupling to be made from the first pad 103 to the second pad 104 through the liquid metal 115.

Some attempts have been made to turn the liquid metal into a paste that is easier to handle. This can be done by adding filler particles to the liquid metal. However, the filler particles that are currently used are ceramic particles. This increases the electrical resistance of the interconnect. Increasing the electrical resistance is problematic since liquid metal (e.g., gallium) already has an electrical resistance that is higher than the electrical resistance of copper and solder. For example, gallium liquid metal is approximately eight times more resistive than solder, and approximately seventeen times more resistive than copper. Furthermore, supply chain issues may arise if industry fully (or largely) converts to liquid metal interconnects. Gallium is already more expensive than solder and copper, and further reducing availability may increase the price of gallium even more.

Accordingly, embodiments disclosed herein include interconnect architectures that comprise a liquid metal matrix with conductive filler particles. The liquid metal matrix that is filled with conductive filler particles becomes an electrically conductive paste. When the filler particles have an electrical resistivity that is lower than the electrical resistivity of the liquid metal, the interconnect has an improved electrical conductivity compared to a pure liquid metal solution. Being in the form of an electrically conductive paste also allows for the easier integration. For example, an interconnect patch with holes may not require a capping layer in order to contain the electrically conductive paste. Instead, the electrically conductive paste may be printed or otherwise dispensed into the holes of the patch, and the patch may be mounted to substrates so that the pads on the substrates directly contact the electrically conductive paste.

The use of low resistivity electrically conductive paste also reduces the cost of interconnects compared to pure liquid metal solutions. For example, the cost of filler particles is generally lower than the cost of the gallium. As such, substituting filler particles for gallium reduces the cost of the interconnect. This may also reduce supply chain concerns since the total volume of gallium is reduced.

Referring now to Figures 2A - 2C, a series of cross-sectional illustrations depicting portions of various devices 200 that include an interconnect between substrates, where the interconnect comprises a liquid metal matrix that is filled with electrically conductive filler particles is shown, in accordance with an embodiment. In such an embodiment, the combination of the liquid metal matrix and the electrically conductive filler particles forms an electrically conductive paste. The electrically conductive pastes described herein include lower electrical resistances compared to liquid metal pastes with ceramic filler particles. Additionally, being in a paste state allows for the wells confining the paste to be formed without capping layers. As such, there is greater flexibility in the types of interconnects that can be formed with such solutions. For example, second level interconnects (SLIs) and/or first level interconnects (FLIs) can utilize the electrically conductive liquid metal-based pastes described herein.

Referring now to Figure 2A, a cross-sectional illustration of a portion of a device 200 is shown, in accordance with an embodiment. In an embodiment, the device 200 is zoomed in on a single interconnect between a first substrate 201 and a second substrate 202. Though, it is to be appreciated that any number of interconnects may be made between the first substrate 201 and the second substrate 202. In an embodiment, the first substrate 201 may be a board, such as a printed circuit board (PCB), a motherboard, or the like. The first substrate 201 may comprise a first pad 203. In the illustrated embodiment, the first pad 203 is recessed into a surface of the first substrate 201. Though, other embodiments may include a first pad 203 that extends up past a surface of the first substrate 201. In an embodiment, the second substrate 202 may comprise a package substrate. For example, the second substrate 202 may comprise a plurality of dielectric buildup layers (e.g., buildup film) with embedded electrical routing (not shown), such as traces, vias, pads, and/or the like. The second substrate 202 may comprise a core (e.g., an organic core, a glass core, or the like), or the second substrate 202 may be a coreless substrate. In embodiments where the first substrate 201 is a board and the second substrate 202 is a package substrate, the interconnect may be considered an SLI. Though, it is to be appreciated that the first substrate 201 and the second substrate 202 may include any type of substrates, and the interconnect may be an interconnect at any level of an electronic package system.

In an embodiment, the interconnect may comprise a patch 210. The patch 210 may have a frame 212 with an opening 216 (which may also sometimes be referred to as a well). The opening 216 may pass through an entire thickness of the frame 212. In an embodiment, the frame 212 is an electrically insulating material. This prevents electrically conductive paste 215 of neighboring interconnects from shorting to each other. For example, the frame 212 may comprise a polymeric material. In the illustrated embodiment, the opening 216 has a width that is substantially equal to widths of the first pad 203 and the second pad 204. Though, the width of the opening 216 may be wider or narrower than the first pad 203 and/or the second pad 204.

In an embodiment, the electrically conductive paste 215 may substantially fill the opening 216. As such, the electrically conductive paste 215 may form direct contact with the first pad 203 and the second pad 204. The direct contact and complete coverage of the electrically conductive paste 215 over the first pad 203 and the second pad 204 may allow for a decrease in the contact resistance. As such, electrical performance of the interconnect may be improved compared to existing solutions.

In an embodiment, the electrically conductive paste 215 comprises a liquid metal matrix 217 that surrounds electrically conductive filler particles 218. In an embodiment, the liquid metal matrix 217 may comprise any suitable liquid metal composition, such as gallium or a gallium alloy. In an embodiment, the electrically conductive filler particles 218 may comprise one or more materials that have an electrical resistivity that is lower than an electrical resistivity of the liquid metal matrix 217. As such, the overall resistance of the electrically conductive paste 215 is lower than a typical liquid metal. For example, the conductive filler particles 218 may comprise one or more of tungsten, iron, cobalt, nickel, chromium, iron alloys (e.g., NiFe, NiCoP, or the like). Such materials generally have a low reactivity with gallium, which tends to be corrosive. However, some embodiments may include even lower resistivity material, such as silver or copper. In some instances, materials like silver and copper are reactive to the gallium. In order to minimize any oxidation, an electrically conductive coating may be applied over the conductive filler particles 218. For example, a tungsten coating may be applied over the conductive filler particles 218 in some embodiments.

In an embodiment, a balance between electrical resistance and assembly compatibility may be made during the development of the composition of the electrically conductive paste 215. For example, lower resistivities may be provided by using larger volume percentages of the conductive filler particles 218, but higher volume percentages make the conductive paste 215 harder to print. That is, if the volume percentage of the conductive filler particles 218 in the conductive paste 215 is too high, the conductive paste 215 begins to act more like a solid and is not able to flow as easily. In some embodiments, the volume percentage of the conductive filler particles 218 in the conductive paste 215 may be approximately 10% or higher, approximately 50% or higher, or up to approximately 80%. In some embodiments, the conductive filler particles 218 may have a volume percentage in the conductive paste 215 that is between approximately 20% and approximately 60%.

In some embodiments, the flow characteristics of the conductive paste 215 may also be impacted by the size and/or shape of the conductive filler particles 218. For example, larger conductive filler particles 218 may provide a conductive paste 215 that is more solid-like, and smaller conductive filler particles 218 may provide a conductive paste 215 that is more liquid-like. In some instances, a dimension (e.g., thickness, width, etc.) of the conductive filler particles 218 may be between approximately 0.10 µm and approximately 10µm. Though, larger or smaller dimensions may also be used. In some embodiments, the conductive filler particles 218 within the conductive paste 215 may all have dimensions that are within 10% of each other, or within 25% of each other. Other embodiments may include conductive filler particles 218 with different dimensions within the conductive paste 215. For example, when the conductive filler particles 218 comprise first metal particles and second metal particles, the first metal particles may have a different dimension than the second metal particles.

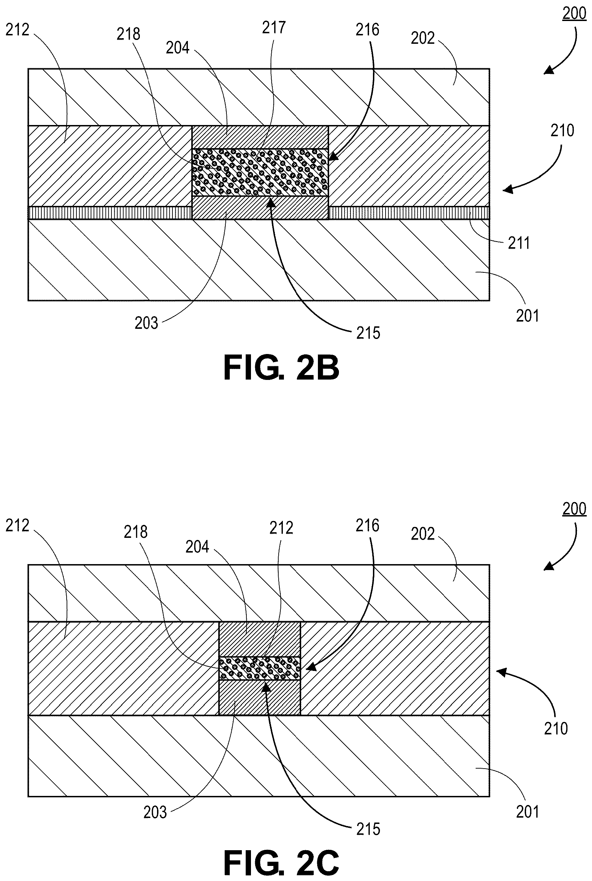

Referring now to Figure 2B, a cross-sectional illustration of a portion of a device 200 is shown, in accordance with an additional embodiment. In an embodiment, the device 200 in Figure 2B may be similar to the device 200 in Figure 2A, with the exception of the coupling of the patch 210 to the first substrate 201 and the second substrate 202. For example, the patch 210 in Figure 2A is directly coupled to the first substrate 201 and the second substrate 202. However, in Figure 2B an adhesive layer 211 may be provided between the frame 212 of the patch 210 and the first substrate 201. In an embodiment, an adhesive layer 211 may also be provided between the frame 212 and the second substrate 202. In an embodiment, the opening 216 may also pass through the adhesive layer 211. That is, the adhesive layer 211 may not be provided between the conductive paste 215 and the first pad 203 and/or the second pad 204.

Referring now to Figure 2C, a cross-sectional illustration of a portion of device 200 is shown, in accordance with an additional embodiment. In an embodiment, the device 200 in Figure 2C is similar to the device 200 in Figure 2A, with the exception of the first pad 203 and the second pad 204. Instead of being recessed into the first substrate 201 and the second substrate 202, respectively, the first pad 203 and the second pad 204 are provided on the surfaces of the first substrate 201 and the second substrate 202. Such an architecture may be similar to typical FLI architectures. For example, the first substrate 201 may be a package substrate, and the second substrate 202 may be a die (e.g., a processor, a memory, etc.).

In such an embodiment, the first pad 203 and the second pad 204 may be provided within the opening 216 of the frame 212. In the illustrated embodiment, the opening 216 may have a width that is substantially similar to a width of the first pad 203 and the second pad 204. Though, in other embodiments the width of the opening 216 may be wider than the width of one or both of the first pad 203 or the second pad 204. When the opening 216 is wider than the width of the first pad 203 and/or the second pad 204, the conductive paste 215 may also cover a sidewall of one or both of the first pad 203 or the second pad 204.

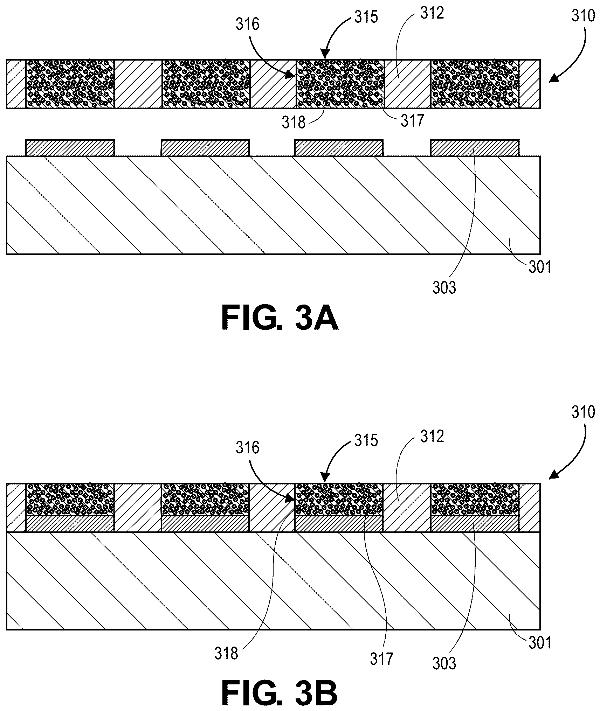

Referring now to Figures 3A - 3D, a series of cross-sectional illustrations depicting a process for assembling a device 300 with a patch that comprises conductive paste 315 interconnects is shown, in accordance with an embodiment.

Referring now to Figure 3A, a cross-sectional illustration of a first substrate 301 is shown, in accordance with an embodiment. In an embodiment, the first substrate 301 may be any type of substrate used in an electronic package system. For example, the first substrate 301 may be a board, a package substrate, an interposer, a die, or the like. In an embodiment, first pads 303 may provided on the first substrate 301. As shown in Figure 3A, the first pads 303 are provided on a top surface of the first substrate 301. Though, in other embodiments, the first pads 303 may be recessed into the first substrate 301 so that top surfaces of the first pads 303 are substantially coplanar with the top surface of the first substrate 301.

In an embodiment, a patch 310 is positioned over the first substrate 301. The patch 310 may comprise a frame 312. The frame 312 may comprise an electrically insulating material, such as a polymer or the like. Openings 316 may be provided through a thickness of the frame 312. In an embodiment, conductive paste 315 may fill the openings 316. The conductive paste 315 may be similar to any of the conductive paste described in greater detail herein. For example, the conductive paste 315 may comprise a liquid metal matrix 317 (e.g., a gallium liquid metal or a gallium alloy liquid metal) that surrounds electrically conductive filler particles 318. The electrically conductive filler particles 318 may have a resistivity that is lower than a resistivity of the liquid metal matrix 317. The electrically conductive filler particles 318 may comprise one or more of tungsten, iron, cobalt, nickel, chromium, iron alloys (e.g., NiFe, NiCoP, or the like). Other embodiments may include even lower resistivity material, such as silver or copper. In order to minimize any oxidation, an electrically conductive coating may be applied over the conductive filler particles 318. For example, a tungsten coating may be applied over the conductive filler particles 318 in some embodiments. A volume percentage of the conductive filler particles 318 may be between 20% and 60% in some embodiments, and a dimension of the conductive filler particles 318 may be between approximately 0.10µm and approximately 10µm.

In an embodiment, the conductive paste 315 may be dispensed into the openings 316 with any suitable deposition process. For example, the conductive paste 315 may be dispensed into the openings 316 with a printing process, such as a screen printing process or the like. Since the conductive paste 315 does not flow like a liquid, the dispensed conductive paste 315 may be retained within the openings 316 without the need for a capping layer. As such, the conductive paste 315 is able to make direct contact with the first pads 303 in a subsequent processing operation.

Referring now to Figure 3B, a cross-sectional illustration of the first substrate 301 after the patch 310 is attached is shown, in accordance with an embodiment. In an embodiment, the patch 310 may be attached to the first substrate 301 with any suitable process. In the illustrated embodiment, the frame 312 directly contacts the first substrate 301. In other embodiments, an adhesive layer (not shown) may be used to attach the frame 312 to the first substrate 301. Additionally, the conductive paste 315 makes direct contact with the first pads 303.

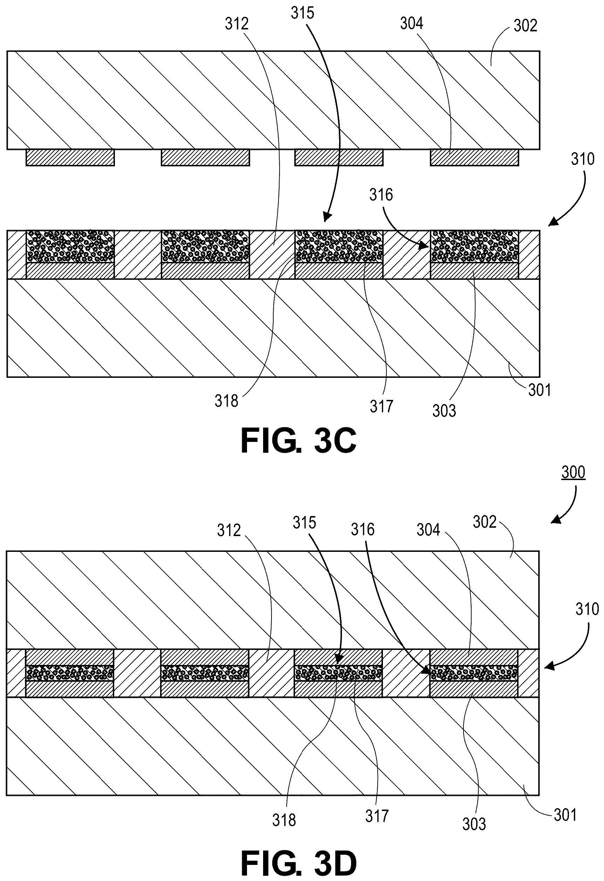

Referring now to Figure 3C, a cross-sectional illustration of the first substrate 301 after a second substrate 302 is positioned over the patch 310 is shown, in accordance with an embodiment. In an embodiment, the second substrate 302 may comprise any type of substrate used in an electronic package system. For example, the second substrate 302 may comprise a board, a package substrate, an interposer, a die, or the like. The second substrate 302 may comprise second pads 304. In an embodiment, the second pads 304 are provided on a bottom surface of the second substrate 302. Though, in other embodiments, the second pads 304 may be recessed into the second substrate 302 so that bottom surfaces of the second pads 304 are substantially coplanar with the bottom surface of the second substrate 302.

Referring now to Figure 3D, a cross-sectional illustration of the device 300 after the second substrate 302 is attached to the patch 310 is shown, in accordance with an embodiment. As shown, the second pads 304 are attached to the patch 310 so that the second pads 304 are in direct contact with the conductive paste 315 in each opening 316. In an embodiment, the conductive paste 315 electrically couples opposing first pads 303 and second pads 304.

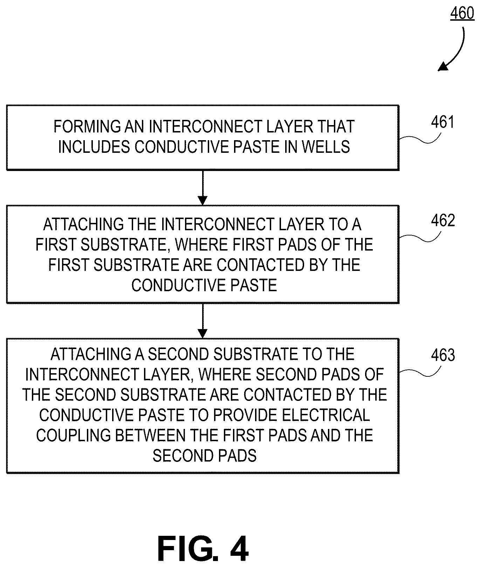

Referring now to Figure 4, a flow diagram that depicts a process 460 for electrically coupling a first substrate to a second substrate with a conductive paste that comprises a liquid metal matrix and electrically conductive filler particles is shown, in accordance with an embodiment. In an embodiment, the process 460 may be similar to the process described above with respect to Figures 3A - 3D.

In an embodiment, the process 460 may begin with operation 461, which comprises forming an interconnect layer that includes conductive paste in wells. In an embodiment, the conductive paste may be similar to any of the conductive pastes described in greater detail herein. For example, the conductive paste may comprise a liquid metal matrix that surrounds electrically conductive filler particles. The electrically conductive filler particles may have resistivities that are lower than the resistivity of the liquid metal matrix. In an embodiment, the electrically conductive paste may be dispensed into the wells with a printing process or the like. Since the interconnect is a paste material, the conductive paste does not leak out of the wells, even when there is no capping layer to cover a top or bottom of the wells. In an embodiment, the interconnect layer may be similar to any of the patches described in greater detail herein.

In an embodiment, the process 460 may continue with operation 462, which comprises attaching the interconnect layer to a first substrate. In an embodiment, the first substrate may comprise pads, and the conductive paste of the interconnect layer may directly contact the pads. In an embodiment, the interconnect layer may directly contact the first substrate, or an adhesive may be used to mechanically couple the interconnect layer to the first substrate.

In an embodiment, the process 460 may continue with operation 463, which comprises attaching a second substrate to the interconnect layer. In an embodiment, pads of the second substrate are directly contacted by the conductive paste to provide electrical coupling between the first pads and the second pads. In an embodiment, the interconnect layer may directly contact the second substrate, or an adhesive may be used to mechanically couple the interconnect layer to the second substrate.

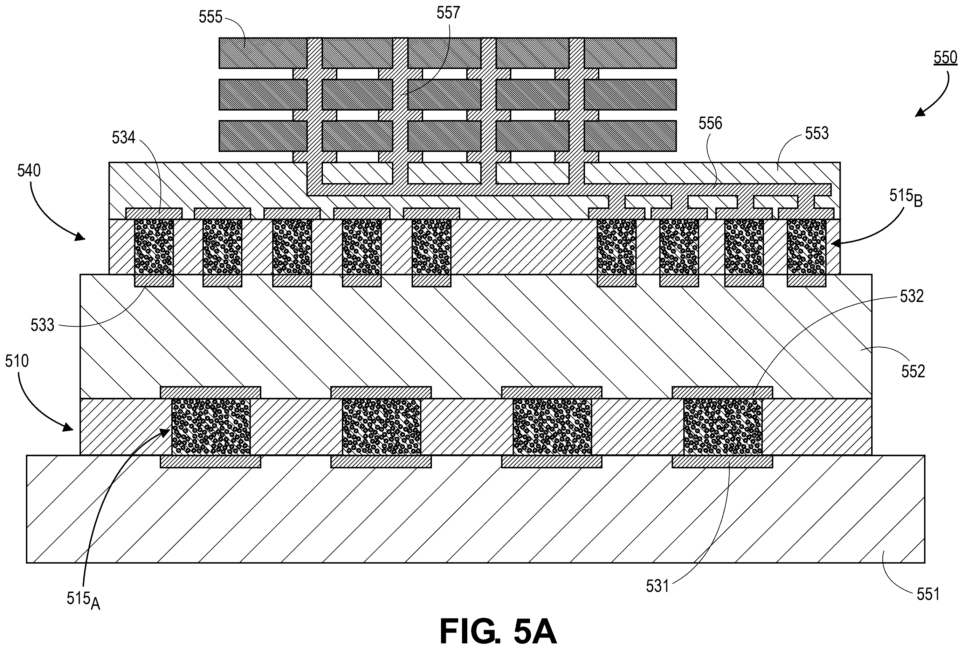

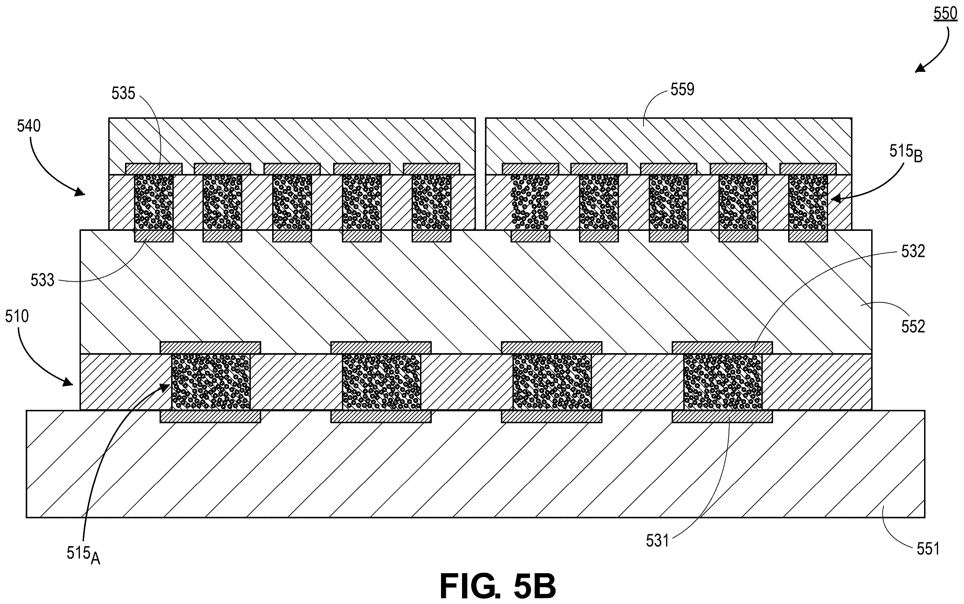

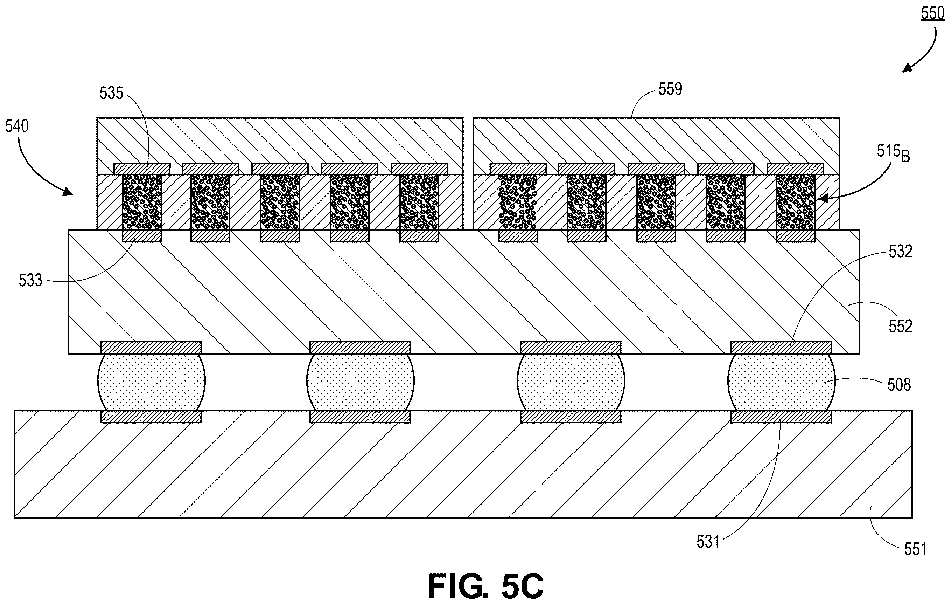

Referring now to Figures 5A - 5C, a series of cross-sectional illustrations depicting electronic packaging systems 550 is shown, in accordance with various embodiments. Figure 5A is a cross-sectional illustration of an electronic packaging system 550 that comprises a stack of memory dies 555 on an interposer 553, Figure 5B is a cross-sectional illustration of an electronic packaging system 550 that comprises liquid metal-based conductive paste interconnects for FLIs and SLIs, and Figure 5C is a cross-sectional illustration of an electronic packaging system 550 that comprises liquid metal-based conductive paste interconnects for FLIs.

Referring now to Figure 5A, a cross-sectional illustration of an electronic packaging system 550 is shown, in accordance with an embodiment. In an embodiment, the electronic packaging system 550 comprises a board 551 that is coupled to a package substrate 552 by an SLI 510. The SLI 510 may comprise a frame with conductive paste 515_{A} that electrically couples pads 531 of the board 551 to pads 532 of the package substrate 552. In an embodiment, the conductive paste 515_{A} may be similar to any of the conductive paste described in greater detail herein. For example, the conductive paste 515_{A} may comprise a liquid metal matrix that surrounds electrically conductive particles.

In an embodiment, an FLI 540 electrically couples the package substrate 552 to an interposer 553. The FLI 540 may comprise a frame with conductive paste 515_{B}. In an embodiment, the conductive paste 515_{B} may be similar to any of the conductive paste described in greater detail herein. For example, the conductive paste 515_{B} may comprise a liquid metal matrix that surrounds electrically conductive particles. In an embodiment, the conductive paste 515_{A} and the conductive paste 515_{B} may comprise the same composition, or different compositions. For example, the filler particles in the conductive paste 515_{A} may be the same or different than the filler particles in the conductive paste 515_{B}. The volume percentage of the filler particles in the conductive paste 515_{A} may be the same or different than the volume percentage of the filler particles in the conductive paste 515_{B}.

In an embodiment, an array of memory dies 555 may be stacked over the interposer 553. The interposer 553 may be a glass interposer, a silicon interposer, or the like. Vias, traces 556 or other electrical routing may be provided within the interposer 553 in order to electrically couple the memory dies 555 to the pads 534 of the interposer 553. In an embodiment, the conductive paste 515_{B} may electrically couple the pads 534 to pads 533 of the package substrate 552. In an embodiment, through silicon vias (TSVs) 557 may be used to electrically couple the memory dies 555 together in some embodiments.

Referring now to Figure 5B, a cross-sectional illustration of an electronic packaging system 550 is shown, in accordance with an additional embodiment. In an embodiment, the electronic packaging system 550 in Figure 5B may be similar to the electronic packaging system 550 in Figure 5A, with the exception of the interposer 553 being omitted. That is, the FLI 540 may directly couple dies 559 to the package substrate 552. For example, pads 535 of the dies 559 may be electrically coupled to the pads 533 of the package substrate 552 by the conductive paste 515_{B} of the FLI 540.

Referring now to Figure 5C, a cross-sectional illustration of an electronic packaging system 550 is shown, in accordance with an additional embodiment. In an embodiment, the electronic packaging system 550 in Figure 5C may be similar to the electronic packaging system 550 in Figure 5B, with the exception of the SLI 510. Instead of a conductive paste 515_{A}, solder interconnects 508 are used to couple the pads 532 of the package substrate 552 to the pads 531 of the board 551. That is, different types of interconnects may be used for different layers of the electronic packaging system 550. While solder interconnects 508 are shown in Figure 5C, it is to be appreciated that any suitable interconnect structure may be used, such as a socket interconnect or the like. In other embodiments, a conductive paste may be used for the electrical coupling between the board 551 and the package substrate 552, and an alternative interconnect architecture (e.g., solder, copper bumps, hybrid bonding, etc.) may be used between the dies 559 and the package substrate 552.

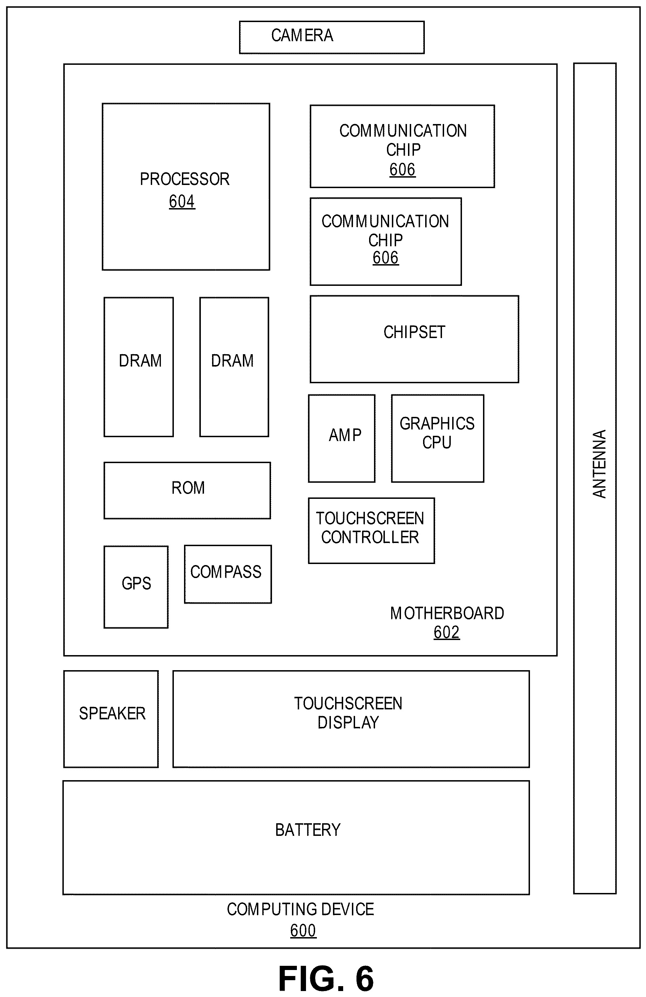

Figure 6 illustrates a computing device 600 in accordance with one implementation of the disclosure. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

These other components include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In some implementations of the disclosure, the integrated circuit die of the processor may be part of an electronic packaging system that comprises an interconnect that includes a conductive paste that comprises a liquid metal matrix that surrounds electrically conductive particles, in accordance with embodiments described herein. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In accordance with another implementation of the disclosure, the integrated circuit die of the communication chip may be part of an electronic packaging system that comprises an interconnect that includes a conductive paste that comprises a liquid metal matrix that surrounds electrically conductive particles, in accordance with embodiments described herein.

In an embodiment, the computing device 600 may be part of any apparatus. For example, the computing device may be part of a personal computer, a server, a mobile device, a tablet, an automobile, or the like. That is, the computing device 600 is not limited to being used for any particular type of system, and the computing device 600 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a first substrate; a first pad on the first substrate, wherein the first pad is electrically conductive; a second substrate over the first substrate; a second pad on the second substrate, wherein the second pad is electrically conductive; and a patch between the first substrate and the second substrate, wherein the patch comprises: a frame; an opening through the frame; and an interconnect within the opening, wherein the interconnect electrically couples the first pad to the second pad, and wherein the interconnect comprises a liquid metal matrix with filler particles that are electrically conductive.

Example 2: the apparatus of Example 1, wherein a volume percentage of the filler particles in the interconnect is between 20 percent and 60 percent.

Example 3: the apparatus of Example 1 or Example 2, wherein the filler particles comprise one or more of tungsten, iron, cobalt, nickel, chromium, silver, copper, or any alloys thereof.

Example 4: the apparatus of Examples 1-3, further comprising: a coating on individual ones of the filler particles.

Example 5: the apparatus of Example 4, wherein the coating comprises tungsten.

Example 6: the apparatus of Examples 1-5, wherein a width of individual filler particles is between 0.10µm and 10µm.

Example 7: the apparatus of Examples 1-6, wherein the first substrate is a board and the second substrate is a package substrate.

Example 8: the apparatus of Examples 1-7, wherein the first substrate is a package substrate and the second substrate is a die.

Example 9: the apparatus of Examples 1-8, wherein the interconnect is a paste.

Example 10: the apparatus of Examples 1-9, wherein the interconnect directly contacts the first pad and the second pad.

Example 11: an apparatus, comprising: a board; a package substrate electrically coupled to the board by a first level interconnect (FLI), wherein the FLI comprises: a polymer layer; a hole through a thickness of the polymer layer; and a conductive material in the hole, wherein the conductive material comprises: gallium; and filler particles surrounded by the gallium, wherein the filler particles are electrically conductive.

Example 12: the apparatus of Example 11, wherein the filler particles have an electrical resistance that is lower than an electrical resistance of the gallium.

Example 13: the apparatus of Example 11 or Example 12, wherein the filler particles comprise one or more of tungsten, iron, cobalt, nickel, chromium, silver, copper, or any alloys thereof.

Example 14: the apparatus of Examples 11-13, wherein individual ones of the filler particles comprise a tungsten coating.

Example 15: the apparatus of Examples 11-14, wherein a volume percentage of the filler particles in the conductive material is between 20 percent and 60 percent.

Example 16: a conductive material, comprising: a liquid metal comprising gallium; filler particles in the liquid metal, wherein the filler particles comprise electrically conductive material, and wherein a volume percentage of the filler particles is between 20 percent and 60 percent.

Example 17: the conductive material of Example 16, wherein the conductive material is a paste.

Example 18: the conductive material of Example 16 or Example 17, wherein the filler particles comprise one or more of tungsten, iron, cobalt, nickel, chromium, silver, copper, or any alloys thereof.

Example 19: the conductive material of Examples 16-18, further comprising: a tungsten coating on individual ones of the filler particles.

Example 20: the conductive material of Examples 16-19, wherein liquid metal has a first resistivity and the filler particles have a second resistivity that is lower than the first resistivity.

## Claims

1. An apparatus, comprising:
a first substrate;
a first pad on the first substrate, wherein the first pad is electrically conductive;
a second substrate over the first substrate;
a second pad on the second substrate, wherein the second pad is electrically conductive; and
a patch between the first substrate and the second substrate, wherein the patch comprises:
a frame;
an opening through the frame; and
an interconnect within the opening, wherein the interconnect electrically couples the first pad to the second pad, and wherein the interconnect comprises a liquid metal matrix with filler particles that are electrically conductive.

2. The apparatus of claim 1, wherein a volume percentage of the filler particles in the interconnect is between 20 percent and 60 percent.

3. The apparatus of claim 1 or 2, wherein the filler particles comprise one or more of tungsten, iron, cobalt, nickel, chromium, silver, copper, or any alloys thereof.

4. The apparatus of claim 1, 2 or 3, further comprising:
a coating on individual ones of the filler particles.

5. The apparatus of claim 4, wherein the coating comprises tungsten.

6. The apparatus of claim 1, 2, 3, 4 or 5, wherein a width of individual filler particles is between 0.10µm and 10µm.

7. The apparatus of claim 1, 2, 3, 4, 5 or 6, wherein the first substrate is a board and the second substrate is a package substrate.

8. The apparatus of claim 1, 2, 3, 4, 5, 6 or 7, wherein the first substrate is a package substrate and the second substrate is a die.

9. The apparatus of claim 1, 2, 3, 4, 5, 6, 7 or 8, wherein the interconnect is a paste.

10. The apparatus of claim 1, 2, 3, 4, 5, 6, 7, 8 or 9, wherein the interconnect directly contacts the first pad and the second pad.

11. A method of fabricating an apparatus, the method comprising:
providing a first substrate having a first pad, wherein the first pad is electrically conductive;
providing a second substrate over the first substrate, the second substrate having a second pad, wherein the second pad is electrically conductive; and
providing a patch between the first substrate and the second substrate, wherein the patch comprises:
a frame;
an opening through the frame; and
an interconnect within the opening, wherein the interconnect electrically couples the first pad to the second pad, and wherein the interconnect comprises a liquid metal matrix with filler particles that are electrically conductive.

12. The method of claim 11, wherein a volume percentage of the filler particles in the interconnect is between 20 percent and 60 percent.

13. The method of claim 11 or 12, wherein the filler particles comprise one or more of tungsten, iron, cobalt, nickel, chromium, silver, copper, or any alloys thereof.

14. The method of claim 11, 12 or 13, further comprising:
providing a coating on individual ones of the filler particles.

15. The method of claim 14, wherein the coating comprises tungsten.
